# EUROPEAN PATENT SPECIFICATION

(11) **EP 4 164 355 B1**
(45) Date of publication and mention of the grant of the patent: **06.08.2025**
(21) Application number: 22306276.1
(22) Date of filing: 29.08.2022
(51) Int. Cl.: H05K 7/20

(54) **DETECTION AND DEFLECTION OF FLUID LEAKAGES IN IMMERSION COOLING SYSTEMS**
DETEKTION UND ABLENKUNG VON FLUIDLECKAGEN IN TAUCHKÜHLSYSTEMEN
DÉTECTION ET DÉVIATION DES FUITES DE FLUIDE DANS LES SYSTÈMES DE REFROIDISSEMENT PAR IMMERSION

(30) Priority: 18.08.2022 EP 22306240
(43) Date of publication of application: 12.04.2023
(73) Proprietor: OVH, 59100 Roubaix (FR)
(72) Inventor: CHEHADE, Ali, 59283 Moncheaux (FR); HNAYNO, Mohamad, 59100 Roubaix (FR)
(74) Representative: BCF Global

(56) References cited:
- EP-A1- 3 518 640
- US-A1- 2022 248 564
- US-B2- 8 453 713

## Description

### FIELD OF TECHNOLOGY

The present technology relates to immersion-cooled electronic processing equipment. In particular, the present technology relates to the detection and deflection of fluid leakages in immersion cooling systems servicing electronic processing equipment.

### BACKGROUND

Electronic equipment, for example servers, memory banks, computer disks, and the like, is conventionally grouped in equipment racks. Large data centers and other large computing facilities may contain thousands of racks supporting thousands or even tens of thousands of rack-mounted electronic assemblies containing servers and associated electronic equipment. The racks, including equipment mounted in their backplanes, consume large amounts of electric power and generate significant amounts of heat, that should be quelled or at least dissipated in order to avoid individual electronic component failures and ensure reliable and consistent operations.

Various cooling measures have been implemented to address the heat generated by the rack-mounted assemblies. One such measure provides a direct liquid cooling block configuration, that is deployed in addition to, or in replacement of, traditional forced-air cooling. In this configuration, cooling plates or blocks are configured with internal conduits to accommodate the circulation of cool channelized liquid (*e.g*., water). These liquid cooling blocks are directly mounted onto heat-generating electronic components, such as processors, to displace heat from the processors into the channelized liquid flowing through the liquid cooling blocks that, in turn, is forwarded towards heat exchangers.

Another cooling measure provides an immersion cooling configuration, in which the heat-generating electronic components of rack-mounted assemblies are submerged in a container that is at least partially filled with a non-conducting cooling fluid, such as, for example, an oilbased dielectric cooling fluid. In this manner efficient thermal contact and heat transfer is achieved between the heat-generating electronic components and the cooling dielectric cooling fluid.

Recently, hybrid liquid cooling systems have been proposed intended to exploit the benefits of both direct liquid cooling block and immersion cooling configurations in order to maximize the overall cooling efficiency of the rack-mounted assemblies. In particular, such liquid cooling systems deploy the liquid cooling blocks directly mounted onto heat-generating electronic components to circulate the cooling channelized liquid in combination with the submergence of the heat-generating electronic components into an immersion dielectric cooling fluid.

However, it has been observed that such liquid cooling systems may be susceptible to certain malfunctions, such as, for example, leakages of the channelized liquid from the coupling components of the liquid cooling block onto the electronic components, the immersion dielectric cooling fluid, and/or other rack-mounted assemblies.

These leakage issues may be particularly problematic, as the channelized cooling liquid may comprise water or other liquids that provide adequate heat transfer performance for channelized cooling but may not be suitable for immersion cooling due to its conductivity and/or corrosive properties of exposed electronic components. For example, if water is used as the channelized cooling liquid, it is likely that the concentration of ions in the water will cause the water to be sufficiently conductive to cause damage to electronic components. And, even if the water is initially distilled or deionized, the concentration of ions will increase as the water is circulated through the channelized cooling system.

As such, there is an interest in developing an arrangement for detecting and deflecting fluid leakages in liquid cooling systems.

It will be appreciated that the subject matter discussed in the background section should not be assumed to be prior art merely based as result of being mentioned in the background section. Similarly, drawbacks indicated in the background section or associated with the subject matter of the background section should not be assumed to have been previously recognized in the prior art. The subject matter in the background section merely represents different approaches.

U.S. Patent Application Publication No. 2022/0248564 discloses an immersion cooling system including a plurality of spaced-apart cooling plated defining a plurality of subvolumes therebetween, a second liquid cooling flowing through at least a portion of each cooling plate, and at least one electronic device at least partially immersed in the first liquid coolant within each subvolume.

European Patent No. 3,518,640 discloses a metal hose connected between a radiator and a cold plate that cools a CPU, or similar electronic heat generating component, whereby the metal hose is connected to the radiator with silicon casings.

### SUMMARY

The embodiments and examples of the present disclosure are provided based on developers' understanding of the drawbacks associated with liquid cooling systems experiencing leakage issues of the liquid cooling blocks within a rack-mounted assembly or onto other rack-mounted assemblies.

The object of the invention is solved by a leakage deflection arrangement according to claim 1, a rack system according to claim 2 and a method according to claim 9. Preferred embodiments are presented in the dependent claims.

In the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

In the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned objects and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

These and other features, aspects and advantages of the present technology will become better understood with regard to the following description, appended claims and accompanying drawings where:
FIG. 1 depicts a perspective view of a rack system housing liquid cooled rack-mounted assemblies, in accordance with the examples of the present disclosure;
FIG. 2 depicts a schematic functional diagram of a fluid leakage detection and deflection arrangement for a liquid-cooled rack-mounted assembly, in accordance with the examples of the present disclosure;
FIG. 3 depicts a block diagram configuration of a fluid deflection structure to individually shield electronic processing components of a liquid-cooled rack-mounted assembly from fluid leakages, in accordance with the examples of the present disclosure;
FIGs. 4A, 4B depict cross-sectional and perspective views of the fluid deflection structure, in accordance with the examples of the present disclosure; and
FIG. 5 depicts a block diagram of a fluid deflection arrangement for shielding an entire electronic device from fluid leakages, in accordance with the examples of the present disclosure.

It will be appreciated that, unless otherwise explicitly specified herein, the representative drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative systems embodying the principles of the present technology.

With these fundamental principles in place, we will now consider some non-limiting examples to illustrate various implementations of aspects of the present disclosure.

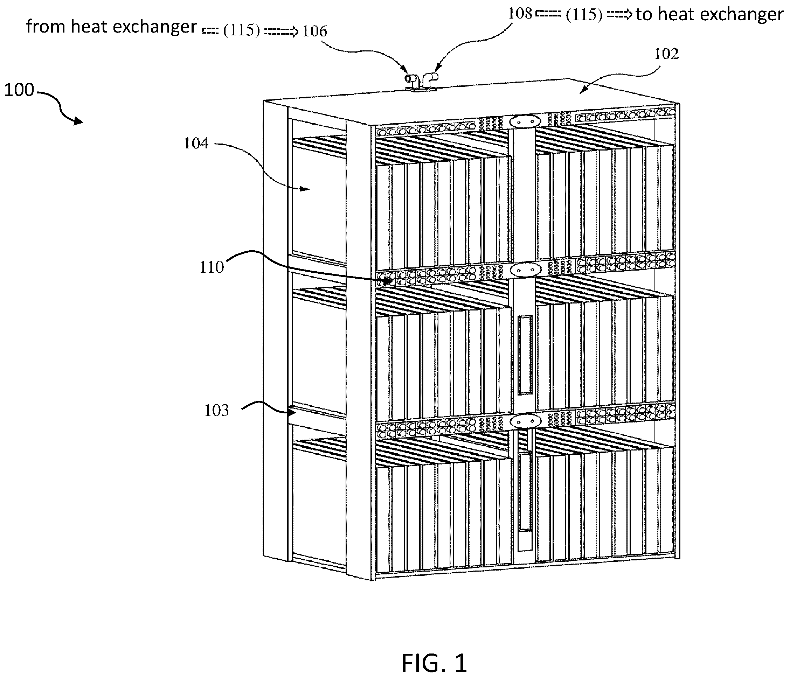

FIG. 1 illustrates a perspective view of a rack system **100** for housing numerous liquid cooled rack-mounted electronic assemblies **104** comprising an electronic device **120** (*e.g.,* server) and associated electronic components **122,** in accordance with the nonlimiting examples of the present disclosure. As shown, the rack system **100** includes a rack frame **102,** racking shelves **103,** rack-mounted electronic assemblies **104,** a power distribution unit (PDU) **110,** a rack liquid cooling inlet conduit **106,** and a rack liquid cooling outlet conduit **108.**

The racking shelves **103** are configured to accommodate the rack-mounted electronic assemblies **104** onto the rack frame **102,** in which the electronic assemblies **104** may be oriented vertically with respect to the rack frame **102** in order to maximize the number of rack-mounted assemblies **104** housed within the rack frame **102.** In some examples, guide members (*not shown*) may be incorporated on racking shelves **103** to slidably guide the rack-mounted assemblies **104** into position during racking and de-racking operations.

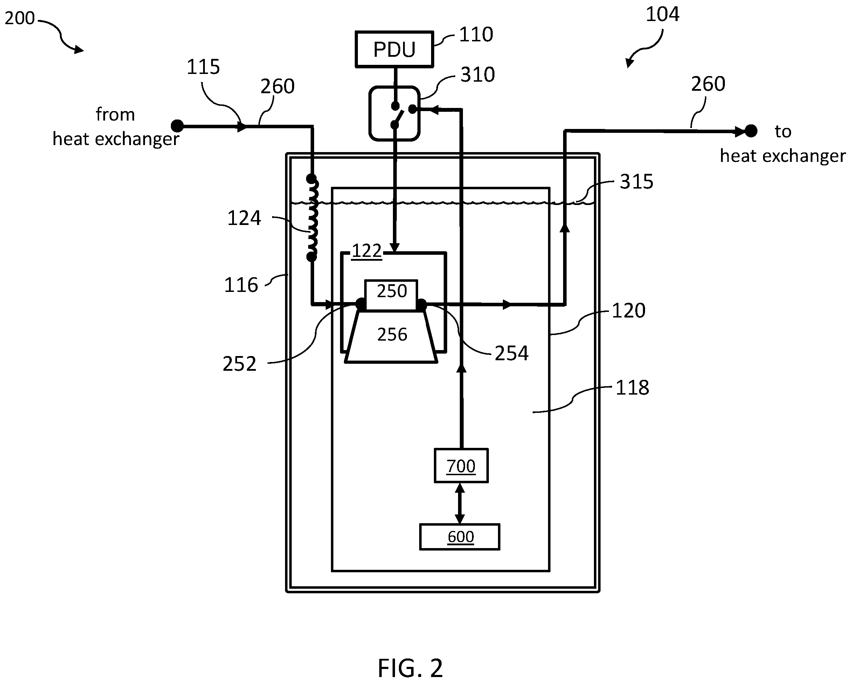

The rack liquid cooling inlet conduit **106** is configured to receive a cooling liquid **115** from an external source (*e.g.,* heat exchanger) that is channely routed to cooling blocks **250** (*as shown in* *FIG. 2*) and are directly mounted onto electronic components **122** (*as shown in* *FIG. 2*) of the rack-mounted electronic assemblies **104.** In turn, the channeled cooling liquid **115** of the cooling blocks **250** that is subjected to the heat generated by the electronic components **122** is subsequently routed to the external source for thermal cooling reconditioning.

The PDU **110** is configured to controllably supply electrical power to the rack-mounted electronic assemblies **104** electronic components **122** (*as shown in* *FIG. 2*)*.* As described in greater detail below, the supply of electrical power by the PDU **110** is monitored and controlled based on a power controller **700** and associated sensors **600** that are communicatively coupled to the PDU **110.**

It should be appreciated that rack system **100** may include other operational components, such as, for example, heat exchangers, cables, connectors, tubing constructs, pumps, and the like. However, such components have been omitted from FIG. 1 for clarity and tractability purposes of the general inventive concepts provided by the disclosed examples.

FIG. 2 depicts a schematic diagram of a fluid leakage detection and deflection arrangement **200** for a liquid cooled rack-mounted electronic assembly **104,** in accordance with the nonlimiting examples of the present disclosure. As shown, the liquid cooled rack-mounted electronic assembly **104** incorporates an electronic device **120** that includes one or more electronic processing components **122** (only one of which is illustrated in FIG. 2 for clarity) mounted on an electronic board **118.** In nonlimiting examples, the electronic device **120** may embody a computer server, such as, for example, a Dell^{™} PowerEdge^{™} Server running a Microsoft^{™} Windows Server^{™} operating system. It will be appreciated, however, that electronic device **120** may be implemented in any other suitable hardware, software, and/or firmware, or a combination thereof.

In the nonlimiting examples provided by the fluid leakage detection and deflection arrangement 200, the liquid cooled rack-mounted electronic assembly **104** incorporates a liquid immersion cooling configuration in combination with a direct liquid cooling block configuration. The liquid immersion cooling configuration deploys an immersion cooling case **116** containing a volume of a first cooling liquid **315,** such as, for example, a dielectric cooling fluid. The electronic board **118** comprising the electronic device **120** and associated electronic processing components **122** are at least partially submerged in the immersion cooling fluid **315** for ambient cooling purposes thereof.

The electronic processing components **122** of the electronic device **120** are additionally cooled by a direct liquid cooling block configuration that channels a second cooling liquid **115** therethrough. The direct liquid cooling block configuration deploys one or more liquid cooling blocks **250** (only one of which is illustrated in FIG. 2 for clarity) that are directly mounted onto the electronic processing components **122** of the electronic device(s) **120** for optimal thermal transfer. The channelized second cooling liquid **115** may comprise any combination of water, alcohol, glycol, or any other suitable liquid capable of sustaining adequate cooling temperatures.

As noted above, the liquid cooling block **250** incorporates an internal conduit to accommodate the circulation of the channelized second cooling liquid **115** therethrough that serves to absorb and extract the heat generated by the electronic processing components **122.** The internal conduit of liquid cooling block **250** may be configured to embody various formations, such as, for example, snake-like, zigzag, and/or looped configurations, *etc.* to maximize the surface area for heat absorption potential of the channelized second cooling liquid **115** flowing through the cooling block **250.**

It should be appreciated that the direct mounting of the liquid cooling blocks **250** onto the electronic processing components **122** is meant to encompass configurations in which thermal pastes or thermally conductive film materials are applied between a surface of the electronic component **122** and an interfacing surface of the liquid cooling block **250.**

Returning to the arrangement **200** of FIG. 2, the channelized second cooling liquid **115** may be supplied by an external source, such as, for example, from a heat exchanger or dry cooler *(not shown)* to the liquid cooling inlet conduit **106** of rack system **100** (*see,* FIG. 1) that, in turn, forwards the cooling liquid **115** via a channelized liquid loop **260,** to an input side of a serpentine convection coil **124.** The serpentine convection coil **124** may be structured with multiple hollow-channel coils to provide a high surface area exposure relative to the the dielectric cooling fluid **315** while also maintaining compact overall length and width dimensions. With this structure, the serpentine convection coil **124** operates to internally convey the circulating channelized second cooling liquid **115** that operates to both, cool the ambient the immersion dielectric cooling fluid **315** as well as forward the channelized cooling liquid **115** to the liquid cooling block **250** in direct thermal contact with the electronic processing components **122.**

As shown, the liquid cooling block **250** is configured with a liquid inlet **252,** fluidly connected to an output side of the serpentine convection coil **124,** for receiving the channelized second cooling liquid **115** from the serpentine convection coil **124.** The received channelized second cooling liquid **115** is then circulated through by the internal conduit of the liquid cooling block **250.** The liquid cooling block **250** further incorporates a liquid outlet **254** for discharging the second cooling liquid **115** warmed by the electronic components **122** to a heat exchanger or dry cooler (*not shown*)*,* via the channelized liquid loop **260,** for thermal cooling reconditioning.

The arrangement **200** may also implement a fluid deflection unit **256** fixedly attached to the liquid cooling block **250.** As explained in greater detail below, the fluid deflection unit **256** operates to shield the electronic processing components **122** from fluid leakages stemming from the liquid cooling block **250** by diverting such leakages away from the electronic processing components **122.** In other words, the fluid deflection unit **256** prevents the electronic components **122** from being in contact with a leaking liquid distinct from the cooling fluid **315** by diverting leaking liquid away from the electronic processing components **122.**

The arrangement **200** may further comprise an electric power controller **700,** a switching device **310,** and one or more measurement sensors **600** communicatively coupled to the controller **500.** The electric power controller **700** may be mounted onto the electronic board **118** of electronic device **120** and may be operatively coupled to the PDU **110** via the switching device **310.** In various examples, the switching device **310** may be integrated within the electronic device **120** or may be located outside the electronic device **120** (*e.g.* along a power line that supplies electric power from the PDU **110** to the electronic device **120).** The power controller **700** is configured to receive signals from the communicatively coupled measurement sensors **600** and execute messages and/or command instructions in response to the received measurement signals.

In various nonlimiting examples, the measurement sensors **600** are disposed at a lower portion of the electronic board **118** and are configured to detect certain properties of the fluid settling at the lower portion of the board **118.** That is, the channelized cooling liquid **115** of the cooling blocks **250** typically has a higher density than the density of the immersion first cooling fluid **315.** As a result, in case of leakages by the cooling blocks **250,** the channelized second cooling liquid **115** will sink to a lower portion of the immersion case **116.** In some examples of the present technology, the measurement sensors **600** are mounted on the fluid deflection unit **256.** In those examples, the measurement sensors **600** are thus disposed near potential leakages that could occur at cooling blocks **250.**

Correspondingly, the measurement sensors **600** are disposed along a lower portion of the immersion case **116** to detect the presence of leaked channelized second cooling liquid **115** based on the measurement of certain properties of the fluid settling at the lower portion of the immersion case **116.** As such, the measurement sensors **600** may be configured to measure one or more physical/chemical properties and the levels of such properties of the fluid along the lower portion the immersion case **116** in order to detect the presence of the channelized second cooling liquid **115.** The detection of the physical/chemical properties and associated levels of the lower portion fluid of immersion case **116** may include, for example, measuring temperature, conductivity, viscosity, density, *etc.*

Upon the measurement sensors **600** detecting that the physical/chemical properties and/or associated levels indicate the presence of the channelized second cooling liquid **115** within the immersion case **116,** the sensors **600** communicate measurement signals reporting the same to the electric power controller **700.** In turn, the controller **500** operates to compare the reported measurement signals providing the physical/chemical property levels against predetermined acceptable threshold levels.

In certain nonlimiting examples, the electric power controller **700** is configured to provide command instructions and messaging signals comprising, *inter alia:* (a) normal operations message in response to sensors **600** reporting that the property levels are within acceptable threshold levels; (b) maintenance check message in response to sensors **600** reporting that the property levels are close to exceeding the threshold levels; and (c) a shutdown alert message along with command instructions to open the switching device **310** to disconnect power supplied by the PDU **110** to the corresponding rack-mounted assembly **104** or to an entire shelf **103** of rack-mounted assemblies **104.** In some examples, the switching device is part of the electronic device **120.** In these examples, the electric power controller **700** may communicate with the electronic device **120** and cause the switching device **310** to electrically disconnect the electronic device **120** from the PDU **110.**

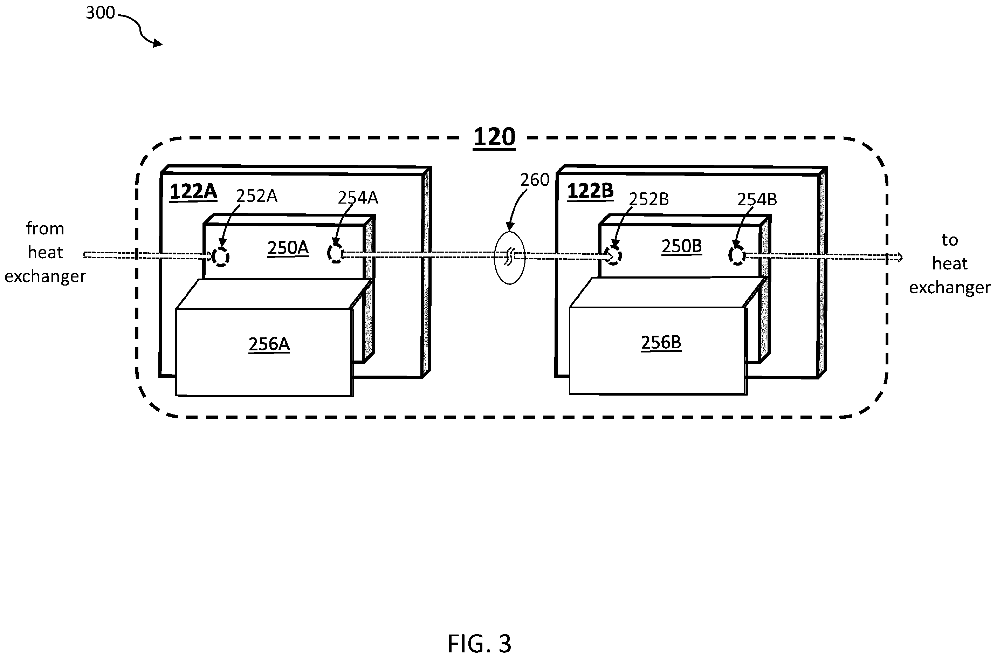

As noted above, the fluid leakage monitoring and deflection arrangement **200** may incorporate a fluid deflection unit **256** mounted onto individual liquid cooling blocks **250** to shield associated electronic processing components **122** from leakages of the channelized second cooling liquid **115** stemming from the liquid cooling block **250.** To this end, FIG. 3 depicts a configuration **300** deploying liquid cooling block fluid deflection units **256A, 256B** configured to shield related electronic processing components **122A, 112B** from fluid leakages, in accordance with the examples of the present disclosure.

As shown, the liquid cooling block fluid deflection units **256A, 256B** are fixedly attached onto respective liquid cooling blocks **250A, 250B** which, in turn, are directly mounted on electronic processing components **122A, 122B** of electronic device **120** (*e.g.,* server). As noted above, the liquid cooling blocks **250A, 250B** receive the channelized second cooling liquid **115** via a channelized liquid loop **260** and internally channel the second cooling liquid **115** therethrough to dissipate the heat generated by related electronic processing components **122A.** Depending on various configurations supported by the disclosed examples, the channelized second cooling liquid **115** may be forwarded to a subsequent liquid cooling block **250B** via the channelized liquid loop **260** (*as shown*) or may be directed back to a cooling liquid source (*e.g.,* heat exchanger) for cooling reconditioning processing.

The attachment of the fluid deflection units **256A, 256B** to the respective liquid cooling blocks **250A, 250B** may be achieved by any suitable means, such as, for example, welding of the fluid deflection units **256A, 256B** to the respective liquid cooling blocks **250A, 250B,** fastening one or more fasteners (e.g. screws) through opening defined in the fluid deflection units **256A, 256B** to the liquid cooling blocks **250A, 250B** or to a plate welded thereon, or any other suitable manner.

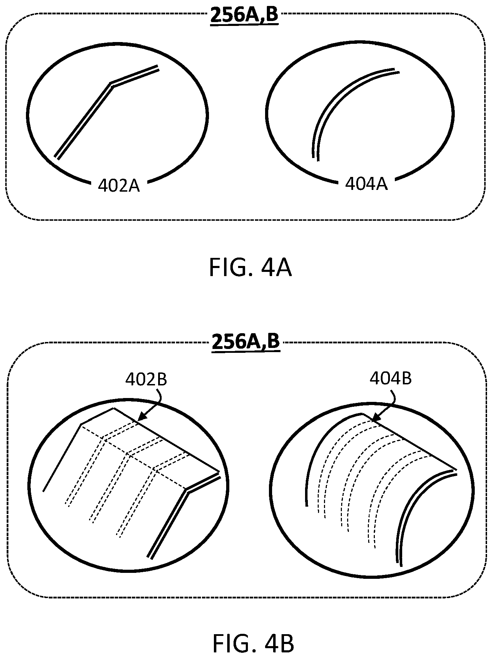

The fluid deflection units **256A, 256B** operate to shield the electronic processing components **122A, 122B** from second cooling liquid **115** leakages stemming from the liquid cooling blocks **250A, 250B** by incorporating an overhanging structure that diverts such leakages away from the electronic processing components **122A, 122B.** To this end, FIGs. 4A, 4B depict cross-sectional and surface perspective views of the structure of the fluid deflection units **256A, 256B,** in accordance with the examples of the present disclosure.

As shown, FIG. 4A depicts nonlimiting examples of cross-sectional profiles of the structure of fluid deflection units **256A, 256B.** In one example, the fluid deflection units **256A, 256B** may embody an overhanging structure incorporating an angular linear cross-sectional profile **402A** configured to downwardly divert fluid leakages away from electronic processing components **122A, 122B.** In an alternative example, the fluid deflection units **256A, 256B** may embody an overhanging structure incorporating a curved cross-sectional profile **402A** configured to downwardly divert fluid leakages away from electronic processing components **122A, 122B.**

FIG. 4B depicts nonlimiting examples of perspective top surface views of the structure of the fluid deflection units **256A, 256B.** As shown, the top surfaces of the fluid deflection units **256A, 256B** may further incorporate grooved channels **402B, 404B** along the angular linear profile **402A** and the curved cross-sectional profile **404A,** respectively. The grooved channels **402B, 404B** are configured to expedite the guidance of diverting fluid leakages away from electronic processing components **122A, 122B.**

In this manner, the fluid leakage detection and deflection arrangement **200** is capable of detecting fluid leakages within an electronic processing assembly **104** as well as divert such leakages stemming from the liquid cooling block **250** away from electronic components **122** within the electronic processing assembly **104.**

However, as indicated above by FIG. 1, rack system **100** comprises a plurality of vertically-disposed rows of horizontal racking shelves **103,** in which each row of the horizontal racking shelves **103** accommodates the placement of multiple rack-mounted electronic assemblies **104.** As such, it will be appreciated that any fluid leakages from rack-mounted electronic assemblies **104** disposed on uppers row of rack system **100** may spill over onto electronic assemblies **104** disposed on lower rows of rack system **100.**

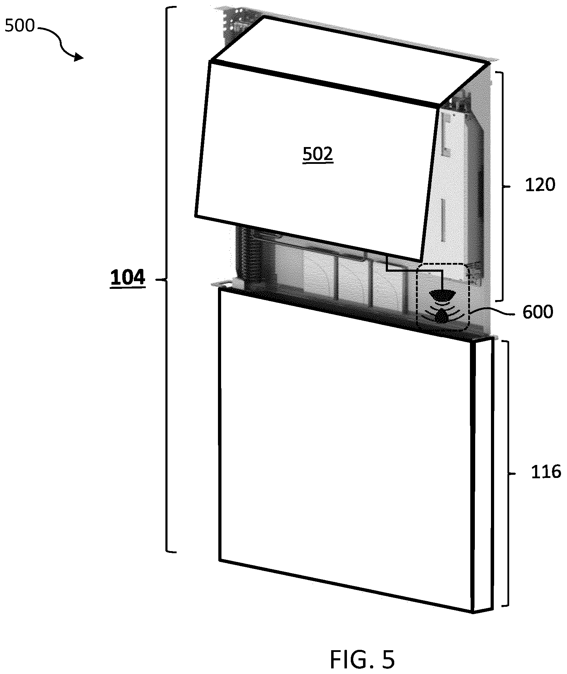

To this end, FIG. 5 depicts a block diagram of a fluid deflection arrangement **500** for shielding an entire rack-mounted electronic processing assembly **104** from fluid leakages stemming from upper rack-mounted electronic assemblies **104** of rack system **100,** in accordance with the examples of the present disclosure. For clarity, FIG. 5 illustrates the rack-mounted electronic processing assembly **104** in an open withdrawn position to indicate the separation of the electronic device **120** (*e.g.,* server) from the immersion case **116.**

As shown, the fluid deflection arrangement **500** incorporates a fluid deflection unit **502** comprising an overhanging structure fixedly attached to an upper portion of the electronic device **120.** The attachment of the fluid deflection unit **502** to the electronic device **120** may be achieved by any suitable means, such as, for example, by fastening fasteners (e.g. screws) through openings defined in the fluid deflection unit **502** and in the board **118.** As another example, the board **118** may define pins on an upper portion thereof (e.g. an upper edge thereof) such that said pins may be inserted in openings defined in the fluid deflection unit **502.** The pins may be adjusted (e.g. bended) to maintain connection between the fluid deflection unit **502** and the board **118.** Other attachment means are contemplated in alternative examples.

Similar to the nonlimiting configurations of fluid deflection units **256A, 256B** noted above, the overhanging structure of fluid deflection unit **502** may embody an angular linear cross-sectional profile or a curved cross-sectional profile to downwardly divert fluid leakages away from the electronic device **120.** Moreover, the top surface of the overhanging structure of fluid deflection unit **502** may also embody grooved channels configured to expedite the guidance of diverting fluid leakages away from the electronic device **120.** The fluid deflection units **256A, 256B** thus divert leaking fluid within the immersion case **116,** while the fluid deflection unit **502** diverts leaking fluid outside the immersion case **116.** The fluid deflection units **256A, 256B** and the fluid deflection unit **502** may be combined in some examples of the present technology such that a given immersion case **116** is operably connected to a fluid deflection unit **502,** and the electronic device **120** enclosed in the immersion case **116** is prevent from being in contact with a leaking liquid distinct from the cooling liquid **315** by fluid deflection units **256A, 256B.**

Equally notable, the fluid deflection arrangement **500** may also incorporate measurement sensors **600** disposed along a lower portion of the immersion case **116** to detect the presence of leaked channelized second cooling liquid **115** based on certain properties of the fluid settling at a lower portion of the immersion case **116.** As noted above, the measurement sensors **600** are communicatively coupled to power controller **700** (*not shown*) and are configured to determine one or more physical/chemical properties and report the levels of such properties to power controller **700.** Depending on the detected property levels reported by the measurement sensors **600,** the power controller **700** may provide command instructions and messaging signals comprising, *inter alia:* (a) normal operations message in response to sensors **600** reporting that the property levels are within acceptable threshold levels; (b) maintenance check message in response to sensors **600** reporting that the property levels are close to exceeding the threshold levels; and (c) a shutdown alert message along with instructions to open the switching device **310** to disconnect power supplied by the PDU **110** to the electronic device **120** of the corresponding rack-mounted assembly **104** or to an entire shelf **103** of rack-mounted assemblies **104.**

In this manner, the fluid deflection arrangement **500** is capable of detecting fluid leakages within an electronic processing assembly **104** as well as shielding an entire rack-mounted electronic processing assembly **104** from such leakages stemming from upper rack-mounted electronic assemblies **104** of rack system **100.**

With this said, it will be understood that, although the embodiments and examples presented herein have been described with reference to specific features and structures, various modifications and combinations may be made without departing from the disclosure. The specification and drawings are, accordingly, to be regarded simply as an illustration of the discussed implementations, embodiments or examples and their principles as defined by the appended claims, and are contemplated to cover any and all modifications, variations, combinations or equivalents that fall within the scope of the present disclosure, as long as they fall under the scope of the appended claims.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A fluid leakage deflection arrangement **(200, 500)** for a liquid-cooled rack-mounted electronic processing assembly **(104),** comprising:
an immersion case **(116)** containing a first cooling liquid **(315)** in which an electronic device **(120)** of the rack-mounted electronic processing assembly **(104)** is at least partially submerged therein, the electronic device **(120)** comprising electronic components **(122);**
the fluid leakage deflection arrangement **(200, 500)** being **characterised in that** the fluid leakage deflection arrangement **(200, 500)** further comprises:
a liquid cooling block **(250)** mounted on the electronic device **(120)** and in thermal contact with the electronic components **(122)** and incorporating an internal conduit to accommodate the circulation of a channelized cooling liquid **(115)** to absorb and extract thermal energy from the electronic components **(122);** and
a deflection unit **(256, 502)** configured to prevent the electronic device **(120)** from being in contact with a leaking channelized cooling liquid by diverting leaking channelized cooling liquid away from the electronic components **(122).**

2. A rack system comprising a plurality of fluid leakage deflection arrangements **(500)** in accordance with claim 1, the rack system being arranged so as to accommodate a bottom and a top rows of immersion cases disposed on top of one another, the deflection units **(256, 502)** of the immersion cases of the bottom row being arranged so as deflect leaking liquid emanating from the immersion cases of the top row.

3. The rack system of claim 2, wherein the deflection unit **(502)** comprises an overhanging structure fixedly attached to an upper portion of the electronic device **(120).**

4. The rack system of claim 3, wherein the overhanging structure is fixedly attached to an upper portion of a board **(118)** of the electronic device **(120).**

5. The arrangement **(200)** of claim 1, wherein the deflection unit **(256)** is fixedly attached to the liquid cooling block **(250).**

6. The arrangement **(200, 500)** of claim 1 or 5, further comprising:
one or more sensors **(600),** disposed within the immersion case **(116),** and configured to measure a level of at least one physical/chemical property of the first cooling liquid **(315)** to detect a presence of a leaking liquid in the immersion case **(116)** and further configured to provide signals reporting the same; and
an electrical power controller **(700)** communicatively coupled to a power distribution unit (PDU) **(110)** supplying electric power to the rack-mounted electronic processing assembly **(104)** and communicatively coupled to the one or more sensors **(600),** the electrical power controller **(700)** configured to receive, assess, and execute commands based on the reported signals from the one or more sensors **(600).**

7. The arrangement **(200, 500)** of claim 6, wherein the measurement of the at least one physical/chemical property of the first cooling liquid **(315)** to detect a presence of a leaking liquid leaking in the immersion case **(116)** comprises measuring at least one of temperature data, conductivity data, viscosity data, and density data.

8. The arrangement **(200, 500)** of claims 6 or 7 wherein, upon assessing the received reporting signals, the electrical power controller **(700)** executes commands to issue at least one of the following instructions:
(i) transmit a normal operations message based on the reported property levels being within an acceptable threshold level;
(ii) transmit a maintenance check message based on the reported property levels being close to a limit of the acceptable threshold level; and
(iii) transmit a shutdown alert message and issue instructions to disconnect the electrical power supplied by the PDU **(110)** to the rack-mounted assembly **(104)** based on the reported property levels exceeding the acceptable threshold level.

9. A method of deflecting fluid leakages in a liquid-cooled rack-mounted electronic processing assembly **(104),** comprising:
partially submerging an electronic device **(120)** of the rack-mounted electronic processing assembly **(104)** within a first cooling liquid **(315)** contained by an immersion case **(116),** the electronic device **(120)** comprising electronic components **(122);**
the method being **characterised in that** it further includes:
mounting a liquid cooling block **(250)** on the electronic device **(120)** such that the liquid cooling block **(250)** is in thermal contact with the electronic components **(122),** the liquid cooling block **(250)** incorporating an internal conduit to accommodate the circulation of a channelized cooling liquid **(115)** to absorb and extract thermal energy from the electronic components **(122);** and
providing a deflection unit **(256, 502)** configured to shield the electronic device **(120)** against fluid leaks that cause the immersion case **(116)** to receive leaking channelized cooling liquid, by diverting the fluid leaks away from the electronic components **(122).**

10. The method of claim 9, wherein the deflection unit **(256, 502)** incorporates grooved channels **(402B, 404B)** on an upper surface thereof to facilitate the diverting of the fluid leaks away from the electronic components **(122).**

11. The method of claims 9 or 10, wherein providing a deflection unit **(256)** further comprises:
fixedly attaching the deflection unit **(256)** to the liquid cooling block **(250)** to shield the electronic device **(120)** against fluid leaks by the channelized cooling liquid **(115)** from the liquid cooling block **(250).**

12. The method of any one of claims 9 to 11, further comprising:
accommodating the liquid-cooled rack-mounted electronic processing assembly **(104)** in a rack system **(100),** the rack system **(100)** being configured to accommodate a plurality of liquid-cooled rack-mounted electronic processing assemblies **(104)** on horizontal racking shelves **(103);**
and wherein:
the deflection unit **(502)** is configured to shield the electronic device **(120)** against fluid leaks from rack-mounted electronic assemblies **(104)** disposed on uppers horizontal racking shelves **(103)** of the rack system **(100).**

13. The method of claim 12, wherein the deflection unit **(502)** comprises an overhanging structure fixedly attached to an upper portion of the electronic device **(120).**

14. The method of claim 13, wherein the overhanging structure is fixedly attached to an upper portion of a board **(118)** of the electronic device **(120).**

## Patentansprüche

1. Fluidleckage-Ablenkungsanordnung **(200, 500)** für eine flüssigkeitsgekühlte, rackmontierte elektronische Verarbeitungsbaugruppe **(104),** umfassend:
ein Tauchgehäuse **(116),** das eine erste Kühlflüssigkeit **(315)** enthält, in der eine elektronische Vorrichtung **(120)** der rackmontierten elektronischen Verarbeitungsbaugruppe **(104)** wenigstens teilweise untergetaucht ist, wobei die elektronische Vorrichtung **(120)** elektronische Komponenten **(122)**umfasst;
wobei die Fluidleckage-Ablenkungsanordnung **(200, 500) dadurch gekennzeichnet ist, dass** die Fluidleckage-Ablenkungsanordnung **(200, 500)** ferner umfasst:
einen Flüssigkeitskühlblock **(250),** der auf der elektronischen Vorrichtung **(120)** montiert und in thermischem Kontakt mit den elektronischen Komponenten **(122)** steht und einen inneren Kanal zur Aufnahme der Zirkulation einer kanalisierten Kühlflüssigkeit **(115)** zur Absorption und Extraktion thermischer Energie aus den elektronischen Komponenten **(122)**aufweist; und
eine Ablenkungseinheit **(256, 502),** die konfiguriert ist, um zu verhindern, dass die elektronische Vorrichtung **(120)** mit einer leckenden kanalisierten Kühlflüssigkeit in Kontakt kommt, indem sie leckende kanalisierte Kühlflüssigkeit von den elektronischen Komponenten **(122)**ableitet.

2. Racksystem, umfassend eine Vielzahl von Fluidleckage-Ablenkungsanordnungen **(500)** gemäß Anspruch 1, wobei das Racksystem so angeordnet ist, dass es eine untere und eine obere Reihe von Tauchgehäusen aufnehmen kann, die übereinander angeordnet sind, wobei die Ablenkungseinheiten **(256, 502)** der Tauchgehäuse der unteren Reihe so angeordnet sind, dass sie aus den Tauchgehäusen der oberen Reihe austretende Flüssigkeitslecks ableiten.

3. Racksystem nach Anspruch 2, wobei die Ablenkungseinheit (502) eine überhängende Konstruktion umfasst, die fest an einem oberen Teil der elektronischen Vorrichtung **(120)**angebracht ist.

4. Racksystem nach Anspruch 3, wobei die überhängende Konstruktion fest an einem oberen Teil einer Platine **(118)** der elektronischen Vorrichtung **(120)**angebracht ist.

5. Anordnung **(200)** nach Anspruch 1, wobei die Ablenkungseinheit **(256)** fest am Flüssigkeitskühlblock **(250)**angebracht ist.

6. Anordnung **(200, 500)** nach Anspruch 1 oder 5, ferner umfassend:
einen oder mehrere Sensoren **(600),** die innerhalb des Tauchgehäuses **(116)**angeordnet und konfiguriert sind, um einen Niveau wenigstens einer physikalischen/chemischen Eigenschaft der ersten Kühlflüssigkeit **(315)** zu messen, um das Vorhandensein einer Leckflüssigkeit im Tauchgehäuse **(116)** zu detektieren, und ferner konfiguriert sind, diesbezügliche Signale zu liefern; und
eine elektrische Leistungssteuerung **(700),** die kommunikativ mit einer Leistungsverteilungseinheit (PDU) **(110)** gekoppelt ist, die die rackmontierte elektronische Verarbeitungsbaugruppe **(104)** mit elektrischer Leistung versorgt, und kommunikativ mit dem einen oder den mehreren Sensoren **(600)**gekoppelt ist, wobei die elektrische Leistungssteuerung **(700)** konfiguriert ist, Befehle basierend auf den gemeldeten Signalen von dem einen oder den mehreren Sensoren **(600)**zu empfangen, zu bewerten und auszuführen.

7. Anordnung **(200, 500)** nach Anspruch 6, wobei das Messen der wenigstens einen physikalischen/chemischen Eigenschaft der ersten Kühlflüssigkeit **(315)** zur Detektion des Vorhandenseins einer Leckflüssigkeit, die in das Tauchgehäuse **(116)** leckt, das Messen wenigstens eines von Temperaturdaten, Leitfähigkeitsdaten, Viskositätsdaten und Dichtedaten umfasst.

8. Anordnung **(200, 500)** nach Anspruch 6 oder 7, wobei, nach der Bewertung der empfangenen Meldesignale, die elektrische Leistungssteuerung **(700)** Befehle zur Ausgabe wenigstens einer der folgenden Anweisungen ausführt:
(i) Übertragen einer Normalbetriebs-Nachricht basierend darauf, dass die gemeldeten Eigenschaftspegel innerhalb eines akzeptablen Schwellenwerts liegen;
(ii) Übertragen einer Wartungsprüfungs-Nachricht basierend darauf, dass die gemeldeten Eigenschaftspegel nahe einer Grenze des akzeptablen Schwellenwerts liegen; und
(iii) Übertragen einer Abschaltwarnungs-Nachricht und Ausgeben von Anweisungen zum Trennen der von der PDU **(110)** an die rackmontierte Baugruppe **(104)** gelieferten elektrischen Leistung basierend darauf, dass die gemeldeten Eigenschaftspegel den akzeptablen Schwellenwert überschreiten.

9. Verfahren zum Ableiten von Fluidleckagen in einer flüssigkeitsgekühlten, rackmontierten elektronischen Verarbeitungsbaugruppe **(104),** umfassend:
Teileintauchen einer elektronischen Vorrichtung **(120)** der rackmontierten elektronischen Verarbeitungsbaugruppe **(104)** in eine erste Kühlflüssigkeit **(315),** die in einem Tauchgehäuse **(116)**enthalten ist, wobei die elektronische Vorrichtung **(120)** elektronische Komponenten **(122)**umfasst;
wobei das Verfahren **dadurch gekennzeichnet ist, dass** es ferner umfasst:
Montieren eines Flüssigkeitskühlblocks **(250)** auf der elektronischen Vorrichtung **(120),** so dass der Flüssigkeitskühlblock **(250)** in thermischem Kontakt mit den elektronischen Komponenten **(122)**steht, wobei der Flüssigkeitskühlblock **(250)** einen inneren Kanal zur Aufnahme der Zirkulation einer kanalisierten Kühlflüssigkeit **(115)** zum Absorbieren und Extrahieren von thermischer Energie aus den elektronischen Komponenten (**122**)aufweist; und
Bereitstellen einer Ablenkungseinheit **(256, 502),** die konfiguriert ist, um die elektronische Vorrichtung **(120)** vor Fluidlecks zu schützen, die dazu führen, dass das Tauchgehäuse **(116)** leckende kanalisierte Kühlflüssigkeit aufnimmt, indem sie die Fluidlecks von den elektronischen Komponenten (**122**)ableitet.

10. Verfahren nach Anspruch 9, wobei die Ablenkungseinheit **(256, 502)** genutete Kanäle **(402B, 404B)** auf einer oberen Oberfläche davon umfasst, um das Ableiten der Fluidlecks von den elektronischen Komponenten (**122**)zu erleichtern.

11. Verfahren nach Anspruch 9 oder 10, wobei Bereitstellen einer Ablenkungseinheit **(256)** ferner umfasst:
festes Anbringen der Ablenkungseinheit **(256)** an dem Flüssigkeitskühlblock **(250),** um die elektronische Vorrichtung **(120)** gegen Fluidlecks durch die kanalisierte Kühlflüssigkeit **(115)** aus dem Flüssigkeitskühlblock (**250**)abzuschirmen.

12. Verfahren nach einem der Ansprüche 9 bis 11, ferner umfassend:
Aufnehmen der flüssigkeitsgekühlten rackmontierten elektronischen Verarbeitungsbaugruppe **(104)** in einem Racksystem **(100),** wobei das Racksystem **(100)** konfiguriert ist, um eine Vielzahl von flüssigkeitsgekühlten rackmontierten elektronischen Verarbeitungsbaugruppen **(104)** auf horizontalen Rack-Regalböden (**103**)aufzunehmen;
und wobei:
die Ablenkungseinheit **(502)** konfiguriert ist, um die elektronische Vorrichtung **(120)** gegen Fluidlecks von rackmontierten elektronischen Baugruppen **(104)** abzuschirmen, die auf oberen horizontalen Rack-Regalböden **(103)** des Racksystems (**100**)angeordnet sind.

13. Verfahren nach Anspruch 12, wobei die Ablenkungseinheit (**502**) eine überhängende Konstruktion umfasst, die fest an einem oberen Teil der elektronischen Vorrichtung (**120**)angebracht ist.

14. Verfahren nach Anspruch 13, wobei die überhängende Konstruktion fest an einem oberen Teil einer Platine (**118**) der elektronischen Vorrichtung (**120**)angebracht ist.

## Revendications

1. Dispositif de déviation de fuite de fluide **(200, 500)** pour un ensemble de traitement électronique monté en rack et refroidi par liquide **(104),** comprenant :
un boîtier d'immersion **(116)** contenant un premier liquide de refroidissement **(315)** dans lequel un dispositif électronique **(120)** de l'ensemble de traitement électronique monté en rack **(104)** est au moins partiellement immergé, le dispositif électronique **(120)** comprenant des composants électroniques **(122)** ;
le dispositif de déviation de fuite de fluide **(200, 500)** étant **caractérisé en ce que** le dispositif de déviation de fuite de fluide **(200, 500)** comprend également :
un bloc de refroidissement liquide **(250)** monté sur le dispositif électronique **(120)** et en contact thermique avec les composants électroniques **(122)** et incorporant un conduit interne pour permettre la circulation d'un liquide de refroidissement canalisé **(115)** pour absorber et extraire l'énergie thermique des composants électroniques **(122)** ; et
une unité de déviation **(256, 502)** configurée pour empêcher le dispositif électronique **(120)** d'être en contact avec une fuite de liquide de refroidissement canalisée en détournant la fuite de liquide de refroidissement canalisée des composants électroniques **(122).**

2. Système en rack comprenant une pluralité de dispositifs de déviation de fuite de fluide **(500)** selon la revendication 1, le système en rack étant agencé de manière à loger une rangée inférieure et une rangée supérieure de boîtiers d'immersion disposés l'un sur l'autre, les unités de déviation **(256, 502)** des boîtiers d'immersion de la rangée inférieure étant agencées de manière à dévier le liquide de fuite émanant des boîtiers d'immersion de la rangée supérieure.

3. Système en rack selon la revendication 2, dans lequel l'unité de déviation **(502)** comprend une structure en surplomb fixée de manière rigide à une partie supérieure du dispositif électronique **(120).**

4. Système en rack selon la revendication 3, dans lequel la structure en surplomb est fixée de manière rigide à une partie supérieure d'un panneau **(118)** du dispositif électronique **(120).**

5. Dispositif **(200)** selon la revendication 1, dans lequel l'unité de déviation **(256)** est fixée de manière rigide au bloc de refroidissement liquide **(250).**

6. Dispositif **(200, 500)** selon la revendication 1 ou 5, comprenant également :
un ou plusieurs capteurs **(600),** disposés à l'intérieur du boîtier d'immersion **(116),** et configurés pour mesurer un niveau d'au moins une propriété physique/chimique du premier liquide de refroidissement **(315)** pour détecter la présence d'une fuite de liquide dans le boîtier d'immersion **(116)** et également configurés pour fournir des signaux rapportant ladite fuite ; et
un contrôleur d'alimentation électrique **(700)** couplé de manière communicative à une unité de distribution d'alimentation (PDU) **(110)** fournissant de l'énergie électrique à l'ensemble de traitement électronique monté en rack **(104)** et couplé de manière communicative à l'un ou les plusieurs capteurs **(600),** le contrôleur d'alimentation électrique **(700)** étant configuré pour recevoir, évaluer et exécuter des commandes sur la base des signaux rapportés par l'un ou les plusieurs capteurs **(600).**

7. Dispositif **(200, 500)** selon la revendication 6, dans lequel la mesure de l'au moins une propriété physique/chimique du premier liquide de refroidissement **(315)** pour détecter la présence d'une fuite de liquide dans le boîtier d'immersion **(116)** comprend la mesure d'au moins une donnée parmi des données de température, des données de conductivité, des données de viscosité et des données de densité.

8. Dispositif **(200, 500)** selon les revendications 6 ou 7, dans lequel, après évaluation des signaux de rapport reçus, le contrôleur d'alimentation électrique **(700)** exécute des commandes pour émettre au moins l'une des instructions suivantes :
(i) transmettre un message de fonctionnement normal lorsque les niveaux de propriété rapportés se situent à un niveau de seuil acceptable ;
(ii) transmettre un message de contrôle de maintenance lorsque les niveaux de propriété rapportés sont proches d'une limite du niveau de seuil acceptable ; et
(iii) transmettre un message d'alerte d'arrêt et émettre des instructions pour déconnecter l'alimentation électrique fournie par le PDU **(110)** à l'ensemble monté en rack **(104)** sur la base des niveaux de propriété rapportés dépassant le niveau de seuil acceptable.

9. Procédé de déviation de fuites de fluide dans un ensemble de traitement électronique monté en rack et refroidi par liquide **(104),** comprenant :
l'immersion partielle d'un dispositif électronique **(120)** de l'ensemble de traitement électronique monté en rack **(104)** dans un premier liquide de refroidissement **(315)** contenu par un boîtier d'immersion **(116),** le dispositif électronique **(120)** comprenant des composants électroniques **(122)** ;
le procédé étant **caractérisé en ce qu'**il comporte également :
le montage d'un bloc de refroidissement liquide **(250)** sur le dispositif électronique **(120)** de sorte que le bloc de refroidissement liquide **(250)** est en contact thermique avec les composants électroniques **(122),** le bloc de refroidissement liquide **(250)** incorporant un conduit interne pour permettre la circulation d'un liquide de refroidissement canalisé **(115)** pour absorber et extraire l'énergie thermique des composants électroniques **(122)** ; et
la fourniture d'une unité de déviation **(256, 502)** configurée pour protéger le dispositif électronique **(120)** contre les fuites de fluide qui amènent le boîtier d'immersion **(116)** à recevoir une fuite de liquide de refroidissement canalisée, en détournant les fuites de fluide des composants électroniques **(122)**.

10. Procédé selon la revendication 9, dans lequel l'unité de déviation **(256, 502)** incorpore des canaux rainurés **(402B, 404B)** sur une surface supérieure de celle-ci pour faciliter la déviation des fuites de fluide des composants électroniques **(122)**.

11. Procédé selon les revendications 9 ou 10, dans lequel la fourniture d'une unité de déviation **(256)** comprend également :
la fixation de manière rigide de l'unité de déviation **(256)** au bloc de refroidissement liquide **(250)** pour protéger le dispositif électronique **(120)** contre les fuites de fluide par le liquide de refroidissement canalisé **(115)** provenant du bloc de refroidissement liquide **(250).**

12. Procédé selon l'une quelconque des revendications 9 à 11, comprenant également :
le logement de l'ensemble de traitement électronique monté en rack et refroidi par liquide **(104)** dans un système en rack **(100),** le système en rack **(100)** étant configuré pour loger une pluralité d'ensembles de traitement électronique montés en rack et refroidis par liquide **(104)** sur des étagères de rack horizontales **(103)** ;
et dans lequel :
l'unité de déviation **(502)** est configurée pour protéger le dispositif électronique **(120)** contre les fuites de fluide provenant d'ensembles électroniques montés en rack **(104)** disposés sur les étagères de rack horizontales supérieures **(103)** du système en rack **(100).**

13. Procédé selon la revendication 12, dans lequel l'unité de déviation **(502)** comprend une structure en surplomb fixée de manière rigide à une partie supérieure du dispositif électronique **(120).**

14. Procédé selon la revendication 13, dans lequel la structure en surplomb est fixée de manière rigide à une partie supérieure d'un panneau **(118)** du dispositif électronique **(120)**.
